# EUROPÄISCHE PATENTANMELDUNG

(11) **EP 1 591 796 A1**
(43) Veröffentlichungstag der Anmeldung: **02.11.2005**
(21) Anmeldenummer: 04010319.4
(22) Anmeldetag: 30.04.2004
(51) Int. Cl.: G01R 31/02, G01R 27/06

(54) **Antennenerkennungssystem**

(71) Anmelder: Delphi Technologies, Inc., Troy, MI 48098 (US)
(72) Erfinder: Nöth, Helmut, 90489 Nürnberg (DE)
(74) Vertreter: Manitz, Finsterwald & Partner GbR

(57) **Zusammenfassung**

Es wird ein System (22) zur Erkennung der ordnungsgemäßen Funktion und/oder des Vorhandenseins einer jeweiligen Antenne (24i) an einem insbesondere einem Autoradio (26) zugeordneten Antennenmodul (28) beschrieben. Es ist eine Messvorrichtung vorgesehen, über die eine jeweilige Antenne mit einer definierten Induktivität (30i) koppelbar und der dadurch gebildete Resonanzkreis (24i,30i) mit einer definierten Frequenz beaufschlagbar ist, um eine entsprechende Resonanzantwort zu erfassen.

## Beschreibung

Die Erfindung betrifft ein System zur Erkennung der ordnungsgemäßen Funktion und/oder des Vorhandenseins einer jeweiligen Antenne an einem insbesondere einem Autoradio zugeordneten Antennenmodul.

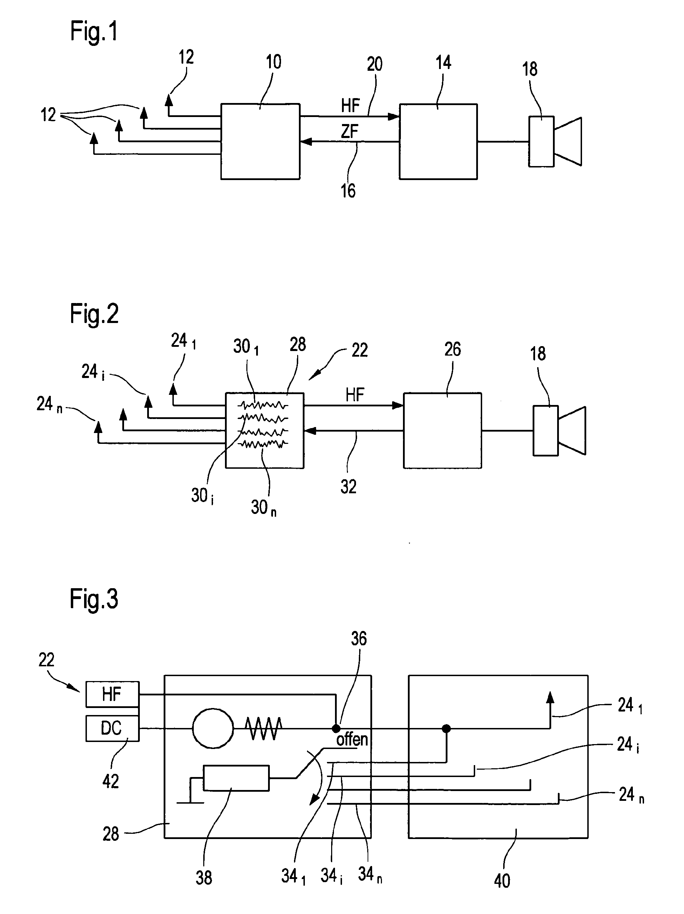

Es ist bekannt, Autoradios mit einer Phantomspeisung für den UKW-MW-Antennen-Eingang auszustatten. Fig. 1 der Zeichnung zeigt in schematischer Darstellung ein herkömmliches System zur Überwachung der ordnungsgemäßen Funktion und des Vorhandenseins eines mit einer solchen Phantomspeisung betriebenen Antennenmoduls 10, das in Abhängigkeit von der Empfangsqualität zwischen mehreren passiven Antennen 12 hin und her schaltet. Dabei wird die Qualität des Empfangssignals im Antennenmodul 10 anhand der Zwischenfrequenz ZF (10,7 MHz) ausgewertet. Das ZF-Signal der aktuellen Empfangsfrequenz wird hierzu vom Radiogerät bzw. Autoradio 14 über eine separate Koaxialleitung 16 zum Antennenmodul 10 zurückgeführt. In der Darstellung gemäß Fig. 1 ist überdies noch ein an das Autoradio 14 angeschlossener Lautsprecher 18 zu erkennen.

Bei dem bekannten System wird die ordnungsgemäße Funktion und das Vorhandensein des Antennenmoduls 10 anhand einer Diagnose mittels Gleichstrommessung an der HF-Leitung 20 und der ZF-Leitung 16 überwacht. Das System kann aber nicht feststellen, ob eine Verbindung zu den einzelnen passiven Antennen 12 vorhanden ist. Dies ist jedoch wünschenswert, da durch einen Fehler dieser Art im vorliegenden Fall kein Ausfall des Gerätes, sondern nur eine Verschlechterung der Empfangsqualität bewirkt wird.

Der Erfindung liegt die Aufgabe zugrunde, ein verbessertes System der eingangs genannten Art anzugeben, bei dem das genannte Problem beseitigt ist. Es soll insbesondere auch die Möglichkeit bestehen, auf möglichst einfache und zuverlässige Art und Weise festzustellen, ob eine Verbindung zu den Einzelantennen vorhanden ist.

Gemäß einer ersten Alternative der Erfindung wird diese Aufgabe gelöst durch eine Messeinrichtung, über die eine jeweilige Antenne mit einer definierten Induktivität koppelbar und der dadurch gebildete Resonanzkreis mit einer definierten Frequenz beaufschlagbar ist, um eine entsprechende Resonanzantwort zu erfassen.

Aufgrund dieser Ausbildung ist auf relativ einfache Art und Weise eine äußert zuverlässige Überwachung des Zustandes der Verbindung zu den einzelnen passiven Antennen gewährleistet.

Bevorzugt liegt die Resonanzfrequenz eines jeweiligen zu bildenden Resonanzkreises unterhalb des LW-Bereiches.

Bevorzugt werden während einer jeweiligen Messphase gleichzeitig mehrere Resonanzkreise gebildet, wobei vorteilhafterweise gleichzeitig sämtliche Resonanzkreise gebildet werden können, um die betreffenden Messungen durchzuführen.

Um eine eindeutige Zuordnung der Resonanzfrequenzen zu erhalten, sind den für unterschiedliche Antennen zu bildenden Resonanzkreisen vorzugsweise unterschiedliche Resonanzfrequenzen zugeordnet.

Eine Erkennung der Einzelantennen an einem Antennenmodul ist beispielsweise über eine Messung der Antennenkapazität durch Erzeugung einer Resonanz möglich. Dabei sendet das Autoradio einen Messton mit definierter Frequenz für jede Einzelantenne an das Antennenmodul. Eine jeweilige Einzelantenne wird für den Messzeitraum an eine für sie definierte Induktivität geschaltet, so dass eine jeweilige vorhandene Einzelantenne mit dem sich ergebenden Resonanzwiderstand antwortet.

Bezüglich des Antennenmoduls wird vorausgesetzt, dass die Einzelantennen mit Induktivitäten gekoppelt sind bzw. werden, die den Empfang nicht beeinflussen. Die Resonanzfrequenz einer jeweiligen, mit der zugeordneten Induktivität gekoppelten Antenne sollte unterhalb des LW-Bereiches liegen. Die Resonanzkreise sollten voneinander entkoppelt sein, so dass jede Resonanz zu erkennen ist und entsprechend ausgemessen werden kann. Es sollte eine eindeutige Zuordnung der Resonanzfrequenzen zu den jeweiligen Antennen sichergestellt sein.

Bezüglich des Radiogeräts oder Autoradios wird vorausgesetzt, dass für die verschiedenen Frequenzen ein jeweiliger Messton erzeugt und ein jeweiliger Antenneneingang so mit dem zugeordneten Messton beaufschlagt wird, dass im Empfangsfall keine Beeinflussung stattfindet.

Gemäß einer alternativen erfindungsgemäßen Lösung wird die zuvor angegebene Aufgabe gelöst durch eine Messeinrichtung, über die ein Messkontakt einer jeweiligen Antenne niederohmig schaltbar und ein Signalkontakt der Antenne mit Strom beaufschlagbar ist, um einen Stromdurchgang vom Signalkontakt über die Antenne und den niederohrriig geschalteten Messkontakt zu erfassen. Für den Empfangsbetrieb wird der Messkontakt wieder hochohmig geschaltet.

Auch in diesem Fall ist auf relativ einfache Art und Weise wieder eine äußerst zuverlässige Überwachung des Zustandes der Verbindung zu einer jeweiligen Einzelantenne möglich.

Bevorzugt ist eine jeweilige Antenne über einen Messwiderstand niederohmig schaltbar, der so bemessen ist, dass sich während der Messung eine erhöhte Stromaufnahme ergibt, die über einer definierten maximal zulässigen Stromaufnahme liegt.

Der Messkontakt einer jeweiligen Antenne ist zweckmäßigerweise zum Antennenmodul geführt und über einen dem Antennenmodul zugeordneten Messwiderstand niederohmig schaltbar.

Der Signalkontakt einer jeweiligen Antenne liegt in der Regel im Antennenmodul vor. Dieser Signalkontakt ist dann über die zu überwachende Verbindung mit der betreffenden Einzelantenne verbunden. Der Signalkontakt einer jeweiligen Antenne kann für eine jeweilige Messung also insbesondere über den Antennenmodul mit Strom beaufschlagt werden.

Zweckmäßigerweise ist ein Messwiderstand für mehrere Antennen vorgesehen, wobei die Messkontakte der Antennen über diesen Messwiderstand entsprechend zeitlich nacheinander niederohmig geschaltet werden.

Zur automatischen Aktivierung einer jeweiligen Messung und/oder Auswertung eines jeweiligen Messergebnisses ist zweckmäßigerweise eine elektronische Steuer- und/oder Auswerteeinrichtung vorgesehen. Eine solche Steuer- und/oder Auswerteeinrichtung kann zumindest teilweise dem Autoradio zugeordnet sein.

Die Erkennung der Einzelantennen an dem Antennenmodul kann also auch über die Messung einer realen Impedanz erfolgen. Dabei kann eine jeweilige Einzelantenne mit zwei zu dem Antennenmodul geführten Kontakten ausgestattet sein, nämlich mit einem Signalkontakt und mit einem Messkontakt. Während der Messzeit wird der Messkontakt niederohmig geschaltet und der Stromdurchgang über die Antenne gemessen. Der Durchgang kann dann anhand der erhöhten Stromaufnahme erfasst werden. Für den Empfangsbetrag muss der Messkontakt hochohmig sein.

Will man den genauen Fehlerort mit erfassen, so muss ein entsprechendes Erkennungsmerkmal angeführt werden, über das bestimmt wird, welche Einzelantenne gerade zu messen ist.

Eine einfache und kostengünstige Lösung besteht hier beispielsweise in einer zeitlichen Codierung mit einem Startzeitpunkt, der unmittelbar auf das Einschalten des Autoradios folgt.

Es kann beispielsweise über einen Timer ein Signal erzeugt werden, das sofort nach Anlegen der Betriebsspannung zum Beispiel alle 100 ms eine andere Antenne mit dem Messkontakt der Messeinrichtung verbindet. Nachdem alle Einzelantennen jeweils für eine bestimmte Zeitdauer, z.B. jeweils 100 ms, mit dem Messwiderstand beaufschlagt wurden, werden die Messkontakte wieder hochohmig geschaltet bzw. geöffnet.

Das Antennenmodul kann somit mit seinen Einzelantennen über die Stromaufnahme beispielsweise jedes Mal zu Beginn des Empfangsbetriebes auf seine Kontakte hin überprüft werden.

Der Messwiderstand sollte möglichst so dimensioniert sein, dass der erhöhte Stromverbrauch während der Messung über der maximal zulässigen Stromverbrauchsgrenze des Moduls liegt.

Über das Radiogerät oder Autoradio bzw. die diesem zugeordnete Steuer- und/oder Auswerteeinrichtung wird nach Anlegen der Phantomspeisung innerhalb der vorgebbaren Zeit der durch den Messwiderstand erhöhte Stromverbrauch im entsprechenden Zeitschlitz gemessen und der jeweiligen Einzelantenne zugeordnet.

Zur Unterscheidung der Antennen kann ein jeweiliges Codiersignal an das Antennenmodul geliefert werden.

Die Erfindung wird im Folgenden anhand von Ausführungsbeispielen unter Bezugnahme auf die Zeichnung näher erläutert; in dieser zeigen:
- Fig. 1: eine schematische Darstellung eines herkömmlichen Systems zur Überwachung der ordnungsgemäßen Funktion und des Vorhandenseins eines Antennenmoduls,
- Fig. 2: eine schematische Darstellung eines beispielhaften Ausführungsbeispiels des erfindungsgemäßen Antennenerkennungssystems, und
- Fig. 3: eine schematische Darstellung einer weiteren Ausführungsform des erfindungsgemäßen Antennenerkennungssystems.

Fig. 2 zeigt in schematischer Darstellung eine beispielhafte Ausführungsform einer ersten Variante eines erfindungsgemäßen Systems 22 zur Erkennung der ordnungsgemäßen Funktion und/oder des Vorhandenseins einer jeweiligen Antenne 24ᵢ an einem insbesondere einem Autoradio 26 zugeordneten Antennenmodul 28.

Das Antennenerkennungssystem 22 umfasst eine Messeinrichtung, über die eine jeweilige Antenne 24ᵢ mit einer definierten Induktivität 30ᵢ koppelbar ist. Der dadurch gebildete Resonanzkreis 24ᵢ, 30ᵢ aus der durch die Antenne 24ᵢ gebildeten Kapazität und der betreffenden Induktivität 30ᵢ wird mit einer definierten Frequenz beaufschlagt, um eine entsprechende Resonanzantwort zu erhalten und über die Messeinrichtung zu erfassen.

Die Resonanzfrequenz eines jeweiligen zu bildenden Resonanzkreises 24ᵢ, 30ᵢ sollte möglichst unterhalb des LW-Bereiches liegen.

Die für unterschiedliche Antennen 24ᵢ zu bildenden Resonanzkreise 24ᵢ, 30ᵢ sollten voneinander entkoppelt sein, so dass jede Resonanz zu erkennen ist und entsprechend ausgemessen werden kann.

Um eine eindeutige Zuordnung der Resonanzfrequenzen zu den betreffenden Antennen 24ᵢ sicherzustellen, sind den für unterschiedliche Antennen 24ᵢ zu bildenden Resonanzkreisen 24ᵢ, 30ᵢ bevorzugt unterschiedliche Resonanzfrequenzen zugeordnet.

Im vorliegenden Fall kann die Antennenerkennung also insbesondere auf der Basis einer Kapazitätsmessung durch Erzeugung einer Resonanz erfolgen. Dazu sendet das Autoradio 26 beispielsweise über eine Koaxialleitung 32 einen Messton mit definierter Frequenz für die jeweiligen Einzelantennen 24ᵢ an das Antennenmodul 28. Die jeweiligen Einzelantennen 24ᵢ werden für den jeweiligen Messzeitraum an eine für sie definierte Induktivität 30ᵢ geschaltet, so dass jede vorhandene Antenne 24ᵢ mit dem Resonanzwiderstand antwortet.

Bezüglich des Antennenmoduls 28 wird vorausgesetzt, dass die einzelnen Antennen 24ᵢ mit Induktivitäten 30ᵢ gekoppelt werden, die den Empfang nicht beeinflussen. Wie bereits erwähnt, sollte die Resonanzfrequenz einer jeweiligen mit der zugeordneten Induktivität 30ᵢ gekoppelten Antenne 24ᵢ unterhalb des LW-Bereiches-liegen. Die Resonanzkreise 24ᵢ, 30ᵢ sollten voneinander entkoppelt sein, so dass jede Resonanz zu sehen ist und ausgemessen werden kann. Es sollte eine eindeutige Zuordnung der Resonanzfrequenzen bestehen.

Bezüglich des Radiogerätes oder Autoradios wird vorausgesetzt, dass der Messton mit den verschiedenen Frequenzen erzeugt und damit der Antenneneingang so beaufschlagt wird, dass im Empfangsfall keine Beeinflussung stattfindet.

Fig. 3 zeigt in schematischer Darstellung eine beispielhafte Ausführungsform eines alternativen erfindungsgemäßen Systems 22 zur Erkennung der ordnungsgemäßen Funktion und/oder des Vorhandenseins einer jeweiligen Antenne 24ᵢ an einem insbesondere einem Autoradio zugeordneten Antennenmodul 28.

Im vorliegenden Fall umfasst das Antennenerkennungssystem 22 eine Messeinrichtung, über die ein Messkontakt 34ᵢ einer jeweiligen Antenne 24ᵢ niederohmig schaltbar und ein Signalkontakt 36 der Antenne mit Strom beaufschlagbar ist, um einen Stromdurchgang vom Signalkontakt 36 über die Antenne 34ᵢ und den niederohmig geschalteten Messkontakt 34ᵢ zu erfassen.

Wie anhand der Fig. 3 zu erkennen ist, kann der Messkontakt 34ᵢ einer jeweiligen Antenne 24ᵢ über einen Messwiderstand 38 niederohmig geschaltet werden. Dieser Messwiderstand 28 ist im vorliegenden Fall so bemessen, dass sich während der Messung eine erhöhte Stromaufnahme ergibt, die über einer definierten maximal zulässigen Stromaufnahme liegt.

Der Messkontakt 34ᵢ einer jeweiligen Antenne 24ᵢ ist zum Antennenmodul 28 geführt und über den Messwiderstand 28, der im vorliegenden Fall den Antennenmodul 28 zugeordnet ist, niederohmig schaltbar. Im vorliegenden Fall liegt der Messwiderstand 38 mit einem Ende an Masse, während sein anderes Ende der Reihe nach mit dem zum Antennenmodul 28 geführten Messkontakten 34ᵢ der verschiedenen Einzelantennen 24ᵢ verbunden werden kann. Diese Einzelantennen können beispielsweise, wie im vorliegenden Fall, an einer Heckscheibe 40 vorgesehen sein.

Der Signalkontakt 36 einer jeweiligen Antenne 24ᵢ ist über den Antennenmodul 28 mit Strom, im vorliegenden Fall beispielsweise mit Gleichstrom aus der Stromquelle 42, beaufschlagbar.

Im vorliegenden Fall erfolgt die Antennenerkennung also beispielsweise über die Messung einer realen Impedanz.

Dabei wird bezüglich des Antennenmoduls 28 und der Einzelantennen 24ᵢ folgendes vorausgesetzt:

Eine jeweilige einzelne Antenne 24ᵢ ist mit zwei zum Antennenmodul 28 geführten Kontakten, nämlich einem Signalkontakt 36 und einem Messkontakt 34ᵢ ausgestattet. Der Messkontakt 34ᵢ muss für den Empfangsbetrieb hochohmig sein. Während der Messzeit wird der Messkontakt 34ᵢ über den Messwiderstand 28 niederohmig geschaltet und der Durchgang über die Antenne gemessen. Der Durchgang kann dann anhand der erhöhten Stromaufnahme erfasst werden.

Um auch den genauen Fehlerort zu erfassen, muss ein Erkennungsmerkmal eingeführt werden, das angibt, welche Einzelantenne 24ᵢ gerade zu testen ist.

Eine einfache, kostengünstige Lösung besteht beispielsweise in der zeitlichen Codierung mit einem unmittelbar auf das Einschalten des Radiogeräts bzw. Autoradios 26 (vgl. auch Fig. 2) folgenden Startzeitpunkt. Beispielsweise durch einen Timer kann ein Signal erzeugt werden, das sofort nach Anlegen der Betriebsspannung beispielsweise alle 100 ms eine andere Antenne 24ᵢ über den jeweiligen Messkontakt 34ᵢ mit dem Messwiderstand 38 der Messeinrichtung verbindet. Nachdem die einzelnen Antennen 24ᵢ jeweils für eine bestimmte Zeitdauer, zum Beispiel für jeweils 100 ms, mit dem Messwiderstand 38 beaufschlagt wurden, werden die Messkontakte 34ᵢ wieder hochohmig geschaltet, was dem in der Fig. 3 mit "offen" bezeichneten Schaltzustand entspricht.

Das Antennenmodul 28 mit seinen einzelnen Antennen 24ᵢ kann also über die Stromaufnahme beispielsweise jeweils zu Beginn des Empfangsbetriebes auf seine Kontakte hin überprüft werden.

Der Messwiderstand 28 sollte so dimensioniert sein, dass der erhöhte Stromverbrauch während der Messung über der maximal zulässigen Stromverbrauchsgrenze des Moduls liegt.

Insbesondere zur automatischen Aktivierung einer jeweiligen Messung und/oder Auswertung eines jeweiligen Messergebnisses ist ebenso wie bei der Ausführungsvariante gemäß Fig. 2 auch bei der vorliegenden Ausführungsvariante gemäß Fig. 3 bevorzugt wieder eine elektronische Steuer- und/oder Auswerteeinrichtung vorgesehen, die zumindest teilweise insbesondere wieder dem Autoradio zugeordnet sein kann.

Das Autoradio bzw. die diesem zugeordnete elektronische Steuerungs- und/oder Auswerteeinrichtung bewirkt nach Anlegen der Phantomspeisung innerhalb des vorgegebenen Zeitrahmens im entsprechenden Zeitschlitz die Messung des durch den Messwiderstand 38 erhöhten Stromverbrauchs sowie die Zuordnung zur jeweiligen Einzelantenne 24ᵢ.

### Bezugszeichenliste

- 10: Antennenmodul
- 12: Antenne
- 14: Autoradio, Radiogerät
- 16: Koaxialleitung, ZF-Leitung
- 18: Lautsprecher
- 20: HF-Leitung
- 22: Antennenerkennungssystem
- 24ᵢ: Antenne
- 26: Autoradio
- 28: Antennenmodul
- 30: Induktivität
- 32: Koaxialleitung
- 34ᵢ: Messkontakt
- 36: Signalkontakt
- 38: Messwiderstand
- 40: Heckscheibe
- 42: Stromquelle

## Patentansprüche

1. System (22) zur Erkennung der ordnungsgemäßen Funktion und/oder des Vorhandenseins einer jeweiligen Antenne (24ᵢ) an einem insbesondere einem Autoradio (26) zugeordneten Antennenmodul (28),
**gekennzeichnet durch**
eine Messeinrichtung, über die eine jeweilige Antenne (24ᵢ) mit einer definierten Induktivität (30ᵢ) koppelbar und der **dadurch** gebildete Resonanzkreis (24ᵢ, 30ᵢ) mit einer definierten Frequenz beaufschlagbar ist, um eine entsprechende Resonanzantwort zu erfassen.

2. System nach Anspruch 1,
**dadurch gekennzeichnet ,**
**dass** die Resonanzfrequenz eines jeweiligen zu bildenden Resonanzkreises (24ᵢ, 30ᵢ) unterhalb des LW-Bereiches liegt.

3. System nach Anspruch 1 oder 2,
**dadurch gekennzeichnet ,**
**dass** die für unterschiedliche Antennen (24ᵢ) zu bildenden Resonanzkreise (24ᵢ, 30ᵢ) voneinander entkoppelt sind.

4. System nach einem der vorhergehenden Ansprüche,
**dadurch gekennzeichnet,**
**dass** während einer jeweiligen Messphase gleichzeitig mehrere Resonanzkreise (24ᵢ, 30ᵢ) gebildet werden.

5. System nach einem der vorhergehenden Ansprüche,
**dadurch gekennzeichnet,**
**dass** dem für unterschiedliche Antennen (24ᵢ) zu bildenden Resonanzkreisen (24ᵢ, 30ᵢ) unterschiedliche Resonanzfrequenzen zugeordnet sind.

6. System (22) zur Erkennung der ordnungsgemäßen Funktion und/oder des Vorhandenseins einer jeweiligen Antenne (24ᵢ) an einem insbesondere einem Autoradio (26) zugeordnetem Antennen-modul (28),
**gekennzeichnet durch**
eine Messeinrichtung, über die ein Messkontakt (34ᵢ) einer jeweiligen Antenne (24ᵢ) niederohmig schaltbar und ein Signalkontakt (36) der Antenne (24ᵢ) mit Strom beaufschlagbar ist, um einen Stromdurchgang vom Signalkontakt (36) über die Antenne (24ᵢ) und den niederohmig geschalteten Messkontakt (34ᵢ) zu erfassen.

7. System nach Anspruch 6,
**dadurch gekennzeichnet,**
**dass** der Messkontakt (34ᵢ) einer jeweiligen Antenne (24ᵢ) über einen Messwiderstand (38) niederohmig schaltbar ist, der so bemessen ist, dass sich während der Messung eine erhöhte Stromaufnahme ergibt, die über einer definierten maximal zulässigen Stromaufnahme liegt.

8. System nach Anspruch 6 oder 7,
**dadurch gekennzeichnet ,**
**dass** der Messkontakt (34ᵢ) einer jeweiligen Antenne (24ᵢ) zum Antennenmodul (28) geführt und über einen dem Antennenmodul (28) zugeordneten Messwiderstand (38) niederohmig schaltbar ist.

9. System nach einem der vorhergehenden Ansprüche,
**dadurch gekennzeichnet,**
**dass** der Signalkontakt (36) einer jeweiligen Antenne (34ᵢ) über den Antennenmodul (28) mit Strom beaufschlagbar ist.

10. System nach einem der vorhergehenden Ansprüche,
**dadurch gekennzeichnet,**
**dass** ein Messwiderstand (38) für mehrere Antennen (24ᵢ) vorgesehen ist und die Messkontakte (34ᵢ) dieser Antennen (24ᵢ) zeitlich nacheinander niederohmig schaltbar sind.

11. System nach einem der vorhergehenden Ansprüche,
**dadurch gekennzeichnet,**
**dass** zur automatischen Aktivierung einer jeweiligen Messung und/oder Auswertung eines jeweiligen Messergebnisses eine elektronische Steuer- und/oder Auswerteeinrichtung vorgesehen ist.

12. System nach Anspruch 11,
**dadurch gekennzeichnet,**
**dass** die elektronische Steuer- und/oder Auswerteeinrichtung zumindest teilweise dem Autoradio zugeordnet ist.

13. System nach einem der vorhergehenden Ansprüche,
**dadurch gekennzeichnet,**
**dass** zur Unterscheidung der Antennen (24ᵢ) ein jeweiliges Codiersignal an das Antennenmodul (28) geliefert wird.
